# EUROPÄISCHE PATENTSCHRIFT

(11) **EP 2 848 424 B1**
(45) Veröffentlichungstag und Bekanntmachung des Hinweises auf die Patenterteilung: **23.10.2019**
(21) Anmeldenummer: 13004467.0
(22) Anmeldetag: 13.09.2013
(51) Int. Cl.: B44B 5/02, B30B 15/02, B44C 3/02

(54) **Verfahren zur Herstellung einer Oberflächenstruktur auf einem Press-werkzeug durch Auftragen von Metallbeschichtungen**
Method for producing a surface structure on a pressing tool by the application of metal coatings
Procédé de fabrication d'une structure de surface sur un outil de presse par l'application de revêtements métalliques

(43) Veröffentlichungstag der Anmeldung: 18.03.2015
(73) Patentinhaber: HUECK Rheinische GmbH, 41747 Viersen (DE)
(72) Erfinder: Stoffel, Wolfgang, 47906 Kempen (DE); Marxen, Martin, 41749 Viersen (DE)
(74) Vertreter: Ofner, Clemens

(56) Entgegenhaltungen:
- EP-A2- 1 629 994
- EP-A2- 2 060 658
- DE-A1- 10 361 119
- DE-A1-102006 022 722
- DE-U1-202010 008 172

## Beschreibung

Die Erfindung betrifft ein Verfahren zur Herstellung einer Oberflächenstruktur auf einem Presswerkzeug, das als ein Pressblech, Endlosband oder eine Prägewalze ausgeführt ist.

Prägewerkzeuge in Form von Pressblechen, Endlosbändern oder Prägewalzen werden in großem Umfang in der holzverarbeitenden Industrie eingesetzt. Hierbei kann es sich um die Herstellung von Möbeln, aber ebenso um die Herstellung von Paneelen für den Innenausbau handeln, wobei die Paneelen im Wand-, Decken- und Bodenbereich eingesetzt werden können. Mithilfe der Prägewerkzeuge wird die sichtbare Oberfläche der Werkstoffplatten insoweit geprägt, dass ein gewünschtes Motiv, vorzugsweise eine naturgetreue Nachbildung einer natürlichen Oberflächenstruktur, hergestellt werden kann. Die Gestaltung der Oberfläche ist hierbei frei wählbar, sodass auch grafische Strukturen oder Muster ausgewählt werden können. Zur Herstellung der Werkstoffplatten werden auf einer Substratschicht, wobei es sich um HDF-, MDF-, USB-, Span- oder Sperrholzplatten handeln kann, harzgetränkte Papierblätter aufgelegt. Die Papierblätter bestehen zumindest aus einem Dekorpapier und einem Overlaypapier, welches oberhalb des Dekorpapiers angeordnet wird. Die Anzahl der Papierschichten ist frei wählbar und richtet sich nach dem vorgesehenen Verwendungszweck, beispielsweise können mehrere Overlaypapiere auf die Dekorschicht aufgelegt werden, oder es können unter die Dekorschicht mehrere Underlaypapiere gelegt werden.

Zur Vermeidung von Krümmungen der Werkstoffplatten werden bevorzugt beide Seiten mit einer annähernd gleichen Zahl von Overlay- und Underlaypapieren beschichtet und mit der Substratschicht verpresst.

Als Harz werden Duroplastharze, beispielsweise in Form von Melamin-, Phenol-, Amino- oder Melamin-/Harnstoffharzen verwendet, welche die Papierlage transparent erscheinen lassen, sodass nur der Druck der Dekorschicht oder einer farbigen Papierlage bei dem fertigen Produkt deutlich sichtbar in Erscheinung tritt.

In Pressenanlagen, beispielsweise in Ein-Etagenpressen, werden die Werkstoffplatten aufgeheizt und mit den Papieren verpresst. Die Presszeit und Temperatur bestimmt den Vernetzungsgrad der Harze und deren Oberflächenqualität. Nach Ablauf der Presszeit hat das Harz den gewünschten Vernetzungsgrad erreicht und befindet sich in einer festen Phase. Bei diesem Vorgang nimmt die Harzoberfläche die Oberflächenstruktur des Prägewerkzeuges an.

Darüber hinaus können die mit Harz getränkten Papierlagen, die beispielsweise aus Natronkraft- und Edelzellstoffpapieren bestehen, miteinander als HPL-Schicht verpresst werden. Einzelne Papierlagen können hierbei bedruckt oder unifarbig gefaltet sein, wobei aufgrund der Transparenz der Papierlagen nach dem Tränken mit den Harzen die Dekormuster bzw. Farbtöne deutlich sichtbar sind. Die Gestaltungsvarianten sind hierbei ebenso wie bei den Werkstoffplatten durch die Dekorpapiere sehr hoch, beispielsweise können diese Stein-, Leder-, Gewebe- oder Holzimitationen aufweisen, wobei durch die eingesetzten Presswerkzeuge diese nach dem Pressvorgang mit einer synchron angeordneten Struktur versehen werden können. Bei der Herstellung der Laminatfußböden werden zum Beispiel Dekorstrukturen mit einer synchron verlaufenden Struktur auf dem Pressblech verpresst und damit die Echtheit der Holzimitation besonders verstärkt hervorgerufen. Die verwendeten Dekorpapiere werden hierbei durch die eingeprägte Struktur überlagert, das heißt es findet eine deckungskonforme Prägung statt, sodass die Vertiefungen beispielsweise dem Verlauf des Motivs folgen und damit die Natürlichkeit der Werkstoffplatten bzw. HPL-Schicht besonders herausstellen. Die HLP-Schicht kann mit einer Substratschicht beispielsweise mittels eines Klebers verbunden werden.

Zur Oberflächengestaltung wird hierzu ein strukturiertes metallisches Pressblech oder Endlosband, vorzugsweise ein Stahlblech, als Prägewerkzeug eingesetzt. Soweit Prägewalzen verwendet werden, können diese auf der Außenfläche ebenfalls eine Struktur aufweisen oder mit einem Prägeblech ummantelt sein. Um die Verschleißfestigkeit und Trenneigenschaften der Metalloberfläche zu verbessern, werden die Prägewerkzeuge zusätzlich mit mit einer Beschichtung versehen. Bei der Beschichtung kann es sich beispielsweise um eine Chrombeschichtung handeln.

Die Herstellung der Presswerkzeuge erfolgte in der Vergangenheit mittels eines Siebdruckverfahrens oder alternativ durch Auftragen einer Fotoschicht, die anschließend einer Belichtung unterzogen wird, um nach abschließender Entwicklung der Fotoschicht die Pressbleche oder Endlosbänder einem Reinigungsvorgang zu unterziehen, sodass nur die Teile der Fotoschicht erhalten bleiben, die die Maske für den späteren Ätzvorgang bilden. Alternativ besteht die Möglichkeit, dass die notwendige Maske mithilfe einer digitalisierten Drucktechnik aufgetragen wird, um das vorbehandelte Presswerkzeug einem Ätzvorgang zu unterziehen. Hierbei können exakt die Daten der Dekorpapiere auch für das Auftragen der Maske verwendet werden, sodass eine besonders ausgeprägte deckungskonforme Prägung bei der endbehandelten Werkstoffplatte hergestellt werden kann. Im letztgenannten Fall wird mithilfe eines Drucckopfes die Maske aufgetragen, wobei ein Druckkopf entlang einer X- und Y-Achse verfahrbar ist oder bei einem feststehenden Druckkopf der Arbeitstisch mit aufliegendem Presswerkzeug unterhalb des Druckkopfes verfahren wird.

EP 1 629 994 A2 offenbart ein Verfahren gemäß dem Oberbegriff von Anspruch 1.

DE 103 61 119 A1 offenbart ein Verfahren zur Herstellung einer Oberflächenstruktur auf einem Metallkörper, umfassend mehrmaliges schichtweises Auftragen einer Maske und einer Metallschicht, wobei auf eine Ätzung verzichtet wird.

Als weitere Alternative besteht die Möglichkeit, eine direkte Strukturierung durch ein Wasserstrahlverfahren oder mithilfe der Lasertechnik vorzunehmen. In diesem Fall braucht zuvor keine Maske zur Oberflächenstrukturierung aufgetragen zu werden.

Unabhängig davon, in welcher Form die Strukturierung der Oberflächen der Presswerkzeuge hergestellt wurde, werden diese mehreren Reinigungsprozessen unterzogen und können zusätzlich mit einer Nickel-, Messing- oder Kupferschicht überzogen werden, um die Oberfläche anschließend durch weitere metallische Beschichtungen zu veredeln. Hierzu wird vorzugsweise eine Chromschicht verwendet. Durch die metallischen Beschichtungen erhält die Oberfläche einen gewünschten Glanzgrad und eine notwendige Oberflächenhärte. Der Glanzgrad ist dafür verantwortlich, dass nach erfolgter Verpressung der zu verarbeitenden Werkstoffplatten mithilfe der Presswerkzeuge die hierbei verpresste Struktur unterschiedliche Schattierungen und Farbspiegelungen erhält.

Sämtliche der aufgezeigten Verfahrenstechniken führen zu einer aufwändigen Bearbeitung der Presswerkzeuge, welche sich letztendlich in den Herstellungskosten wiederspiegeln. Insbesondere das mehrmalige Ätzen der Presswerkzeuge erfordert lange Bearbeitungszeiten.

Aus den vorgenannten Gründen liegt daher der vorliegenden Erfindung die Aufgabe zugrunde, ein neuartiges Verfahren aufzuzeigen, bei dem nahezu vollständig auf Ätzverfahren verzichtet werden kann.

Die Aufgabe der Erfindung wird gelöst durch das Verfahren des Anspruchs 1.

Weitere vorteilhafte Ausgestaltungen des Verfahrens ergeben sich aus den Unteransprüchen.

Zur Herstellung der Oberflächenstruktur wird nach dem vorgeschlagenen Verfahren auf eine Ätzung verzichtet. Stattdessen wird auf ein vorbereitetes Presswerkzeug, hierbei handelt es sich zunächst nur um ein Stahlblech, zumindest einmal eine Maske aufgetragen, um partielle Bereiche der Oberfläche abzudecken. Nach Fertigstellung der Maske wird durch zumindest einmaliges Auftragen einer Metallschicht auf die nicht abgedeckten Bereiche eine erste Metallschicht zum Aufbau einer aus Erhebungen bestehenden Oberflächenstruktur aufgetragen.

Bereits durch das Auftragen einer ersten Metallbeschichtung erfolgt eine leichte Oberflächenstrukturierung, die durch mehrmaliges Wiederholen der einzelnen Verfahrensschritte, wie erneutes Auftragen einer Maske und nochmaliges Auftragen einer Metallschicht, zu einem schichtweisen Aufbau der Erhebungen führt. Die Anzahl der hierbei aufzutragenden Schichten wird hierbei lediglich durch die Tiefe der zu erzielenden Oberflächenstruktur bestimmt. Im Bedarfsfall können eine Vielzahl von Einzelschichten übereinander aufgetragen werden, wobei für das Auftragen einer neuen Metallschicht zuvor eine neue Maske aufgetragen werden muss. Dadurch, dass auf diese Art und Weise durch die Anordnung von mehreren Metallschichten übereinander quasi eine pyramidenförmige Struktur entsteht, kann im einfachsten Fall auf das Entfernen der zuvor aufgetragenen Maske verzichtet werden. Vielmehr kann eine weitere Maske unmittelbar auf der vorhandenen Maske und weiteren Teilbereichen der Metallschicht aufgetragen werden. Sobald die Anzahl der aufgetragenen Schichten der später gewünschten Strukturtiefe entsprechen, können sämtliche Masken in einem Arbeitsgang entfernt werden. Alternativ besteht selbstverständlich die Möglichkeit, dass vor dem Auftragen einer neuen Maske die bisherige Maske entfernt wird.

Der Vorteil einer solchen Vorgehensweise besteht darin, dass auf eine Ätzung der Presswerkzeuge bei diesen Verfahrensschritten gänzlich verzichtet werden kann. Die Herstellung der Oberflächenstruktur erfolgt nur durch Auftragen weiterer Metallschichten, die übereinander angeordnet sind. Für die Metallschicht kann beispielsweise eine Nickel-, Kupfer- oder Chromschicht aufgetragen werden. Nach Beendigung der Oberflächenstrukturierung kann zusätzlich eine Hartchromschicht aufgetragen werden.

Für das Auftragen der Maske ist erfindungsgemäß eine digitale Drucktechnik vorgesehen, wobei vorzugsweise ein UV-Lack verwendet wird, welcher nach dem Auftragen durch eine UV-Quelle zum Aushärten bestrahlt wird. Das Auftragen der Maske erfolgt hierbei auf einem Arbeitstisch mithilfe eines Druckkopfes, welcher in der durch die X- und Y-Komponente aufgespannten Ebene verfahrbar angeordnet ist. Alternativ besteht die Möglichkeit, dass ein feststehender Druckkopf eingesetzt wird und der Arbeitstisch zusammen mit dem Presswerkzeug in X- und Y-Richtung verfahren wird.

Zur Oberflächenstrukturierung ist in weiterer Ausgestaltung des Verfahrens vorgesehen, dass die nachfolgenden Masken auf annähernd die gleichen partiellen Bereiche aufgetragen werden. Durch die erste aufgetragene Maske wird hierbei quasi der Bereich festgelegt, der die späteren Vertiefungen bildet, während demgegenüber in den nicht abgedeckten Bereichen sukzessive die Oberflächenstruktur durch das Auftragen mehrerer Metallschichten entsteht. Aus diesem Grunde liegen die einzelnen Masken entweder übereinander, wenn zuvor die älteren Masken nicht entfernt werden, oder es werden die gleichen Bereiche und Randbereiche der Metallbeschichtung mit den Masken abgedeckt, um die weiteren Beschichtungsvorgänge nur in den erhabenen Bereichen zu ermöglichen. Die Metallschichten werden insofern übereinander aufgetragen, wodurch eine schichtweise erhabene Struktur senkrecht zur Oberfläche des Presswerkzeuges entsteht. Um die pyramidenförmige Struktur zu realisieren, zeichnen sich die nachfolgend aufgetragenen Masken durch eine breiter werdende Strichstärke aus, die kontinuierlich ansteigt, bis letztendlich nur noch die schmalen Bereiche der Erhebungen damit eine letzte Metallschicht hergestellt werden.

Zur besseren Haftung der aufzutragenden Masken oder einer erforderlichen Vorbehandlung der Presswerkzeuge ist in weiterer Ausgestaltung der Erfindung vorgesehen, dass die Oberfläche des Presswerkzeuges vor der ersten Maskenauftragung galvanisch, chemisch oder mechanisch vorbehandelt wird, um beispielsweise ein Aufrauen der Metalloberfläche zu erzielen.

Nachdem die einzelnen Metallschichten pyramidenförmig übereinander angeordnet wurden, ist in weiterer Ausgestaltung der Erfindung vorgesehen, dass die Oberfläche des Presswerkzeuges nach dem Aufbringen der letzten Metallschicht einer galvanischen, chemischen oder mechanischen Behandlung unterzogen wird. Hierbei könnte ein Ätzverfahren angewendet werden, um eine Rundung der schichtweise aufgetragenen Metallschichten vorzunehmen. Ferner kann mithilfe der weiteren Behandlungsschritte eine Veredlung des Presswerkzeuges herbeigeführt werden, wobei die nachfolgende Oberflächenbearbeitung beispielsweise durch Elektropolieren oder mechanisches Polieren erfolgt, um einen bestimmten Glanzgrad herzustellen. Alternativ besteht die Möglichkeit, den Glanzgrad durch Ätzen oder Mattätzen bei einer nachfolgenden Oberflächenbearbeitung herzustellen. Bei dieser Vorgehensweise wird sich der Glanzgrad über die gesamte Oberfläche des Presswerkzeuges in der Regel gleichmäßig einstellen.

Um einen unterschiedlichen Glanzgrad herzustellen, ist in weiterer Ausgestaltung der Erfindung vorgesehen, dass eine vollflächige und/oder partielle Glanzgraderstellung als nachfolgende Oberflächenbehandlung erfolgt, wobei der Glanzgrad durch Auftragen einer metallischen Beschichtung, durch ein chemisches Verfahren oder durch ein mechanisches Verfahren eingestellt wird. Alternativ besteht auch in diesem Fall die Möglichkeit, durch Ätzen oder Mattätzen eine Glanzgradeinstellung vorzunehmen. Im Wesentlichen kommt es hier auf den Verwendungszweck der Werkstoffplatten an, soweit die hergestellten Werkstoffplatten für die Möbelindustrie eingesetzt werden, erfolgt ein chemisches oder ein mechanisches Behandlungsverfahren zur Einstellung des Glanzgrades und anschließende Hartverchromung. Soweit die Werkstoffplatten zur Herstellung von Fußbodenpaneelen verwendet werden können ohne weiteres weitere metallische Beschichtungen zur Einstellung des Glanzgrades aufgetragen werden, wobei ein erster Glanzgrad im Bereich der Erhebung der Presswerkzeuge bereits bei der Oberflächenstrukturierung eingestellt werden kann.

In weiterer Ausgestaltung der Erfindung ist vorgesehen, dass eine vollflächige und/oder partielle Glanzgradeinstellung als nachfolgende Oberflächenbehandlung erfolgt. Durch die Ausbildung partieller Hartchromschichten besteht hierbei ebenso die Möglichkeit, den Glanzgrad zu beeinflussen und beispielsweise die Vertiefungen in einem anderen Glanzgrad erscheinen zu lassen als die Erhebungen, zunächst als Negativabdruck auf dem Presswerkzeug und anschließend nach der Verpressung auf der Oberfläche der Werkstoffplatte. Welche Bereiche hierbei einen niedrigen und welche Bereiche einen hohen Glanzgrad aufweisen sollen, liegt allein im Ermessen des Kunden, wie er das Endprodukt herstellen möchte. Durch die aufgezeigten Verfahrensschritte besteht grundsätzlich jede Gestaltungsmöglichkeit hinsichtlich des Glanzgrades.

Der wesentliche Erfindungsgedanke des vorliegenden Verfahrens besteht hierbei darin, dass auf eine Ätzung zur Herstellung der Oberflächenstruktur verzichtet wird und nach dem Auftragen von einzelnen Masken eine partielle Beschichtung mithilfe einer Metallschicht erfolgt, wobei sich dies mehrmals wiederholt, bis die gewünschte Oberflächenstruktur schichtweise entstanden ist.

Die Erfindung wird im Weiteren anhand der Figuren näher erläutert.

Es zeigt
Fig. 1 : in einer perspektivischen Ansicht ein Pressblech mit einer Oberflächenstrukturierung,
Fig. 2 : in einer stark vergrößerten Querschnittsansicht das aus Figur 1 bekannte Pressblech mit einer schichtweise aufgetragenen Oberflächenstruktur und
Fig. 3 : in einer Draufsicht eine Vorrichtung zur Durchführung des erfindungsgemäßen Verfahrens.

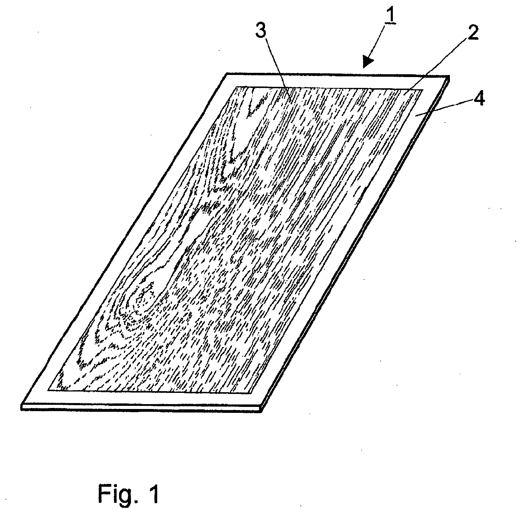

Figur 1 zeigt in einer perspektivischen Ansicht ein Pressblech 1 mit einer Oberflächenstrukturierung, welches aus einem Stahl- oder Messingblech bestehen kann. Auf der Oberfläche 2 des Pressbleches 1 ist eine Holzmaserung 3 nachgebildet, die beispielsweise durch mehrmaliges Auftragen einer Maske und anschließender Metallbeschichtung hergestellt wurde. Grundsätzlich kann jede Oberflächenstrukturierung hergestellt werden, beispielsweise die Nachbildung einer Natursteinoberfläche eines geografischen Musters oder alternativer Holzstrukturen.

Ein umlaufender Rand 4 dient hierbei zur Aufnahme und Erfassung innerhalb einer nicht dargestellten hydraulischen Ein- oder Mehretagenpresse.

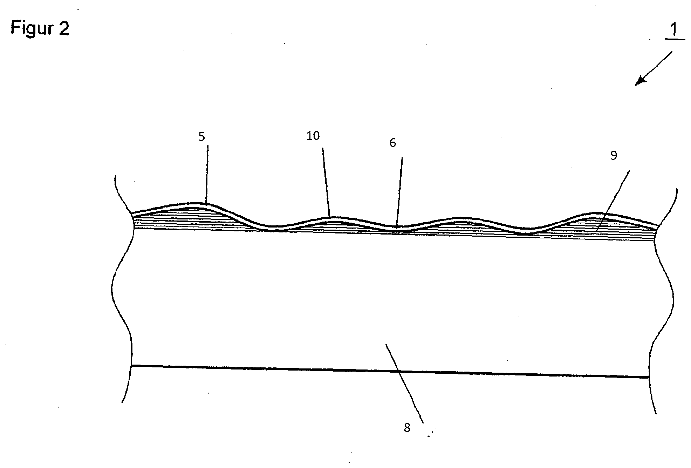

Figur 2 zeigt in einer stark vergrößerten Schnittansicht das Pressblech 1, aus der ersichtlich wird, dass das Pressblech 1 aus einem Trägerkörper 8 besteht, auf den einzelne Schichten 9 aus Metall übereinander angeordnet sind. Die Schichtenstruktur entsteht hierbei durch das Auftragen einer Maske auf partielle Bereiche des Trägerkörpers 8 und anschließender Metallbeschichtung, die mehrmals wiederholt wird. Hierzu ist es jeweils erforderlich, eine neue Maske aufzutragen und eine neue Metallbeschichtung bis zur gewünschten Strukturtiefe, welche durch die erhabenen Bereiche 5 und durch die tiefer liegenden Bereiche 6 ausgebildet sind. In der Draufsicht ergeben die Bereiche 5 und 6 eine Struktur, wie sie beispielsweise aus Figur 1 mit einer Imitation eines Holzdekors entstanden ist. Das erfindungsgemäße Verfahren sieht hierbei vor, dass auf die Ätzung der Oberflächenstruktur verzichtet wird und stattdessen nach jedem Auftragen einer Maske einzelne Metallschichten aufgetragen werden. Über die Anzahl der Metallschichten 3 kann hierbei das Tiefenprofil eingestellt werden. Auf die Metallschichten 3 wird zum Abschluss eine Hartchromschicht 10 aufgetragen, die sich beispielsweise über die gesamte Oberfläche des Pressbleches 1 erstrecken kann. Alternativ besteht aber auch hier die Möglichkeit, die Hartchromschicht 10 nur im Bereich der tiefer liegenden Bereiche 6 aufzutragen, während demgegenüber die erhabenen Bereiche 5 mit einer anderen Chromschicht bedeckt werden, welche beispielsweise einen anderen Glanzgrad aufweist. Durch diese Maßnahme kann nicht nur die Strukturierung, sondern auch eine Glanzgradeinstellung der mit den Pressblechen 1 herzustellenden Werkstoffplatten erfolgen.

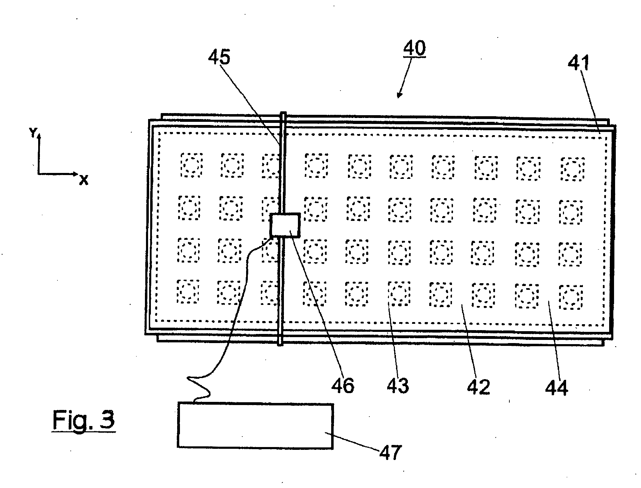

Figur 3 zeigt in einer Draufsicht eine Vorrichtung 40 zur Durchführung des erfindungsgemäßen Verfahrens mit einem Druckkopf 46. Die Vorrichtung 40 besteht aus einem Auflagetisch 41 mit einer ebenen Arbeitsfläche 42. Innerhalb der Arbeitsfläche 42 sind Vertiefungen 43 ausgebildet, die mit einer Vakuumpumpe verbunden sind, sodass ein auf der Arbeitsfläche 42 aufliegendes Pressblech 1 angesaugt und damit für die weiteren Bearbeitungsvorgänge fixiert werden kann. Über eine Traverse 45 ist ein Druckkopf 46 in Richtung der Y-Koordinate bewegbar. Die Traverse 45 ist demgegenüber in Richtung der X-Koordinate bewegbar, sodass der Druckkopf 46 jeden Punkt der Oberfläche des Pressbleches 1 erreichen kann. Anstelle der Bewegung des Druckkopf 46 könnte auch ein feststehender Druckkopf 46 verwendet werden und die Arbeitsfläche 42 mit aufliegendem Pressblech 1 in X- und Y-Richtung bewegt werden.

Über eine Steuereinheit 47 wird die Verfahrbarkeit der Traverse 45 und des Druckkopfes 46 vorgenommen, wobei diese über digitalisierte Daten einer abgeformten 3D-Struktur angesteuert wird. Nach Fertigstellung der Maske kann das Pressblech 46 mit einer Metallschicht versehen werden.

### Bezugszeichenaufstellung

1 : Pressblech
2 : Oberfläche
3 : Holzmaserung
4 : Rand
5 : Bereich
6 : Bereich
7 : Hartchromschicht
8 : Trägerkörper
9 : Schicht
10 : Hartverchromung
40 : Vorrichtung
41 : Auflagetisch
42 : Arbeitsfläche
43 : Vertiefung
45 : Traverse
46 : Druckkopf
47 : Steuereinheit

## Patentansprüche

1. Verfahren zur Herstellung einer Oberflächenstruktur auf einem Presswerkzeug, das als Pressblech (1), Endlosband oder Prägewalze ausgeführt ist, umfassend zumindest die Schritte:
- wenigstens einmaliges Auftragen einer Maske, um partielle Bereiche abzudecken und
- zumindest einmaliges Auftragen einer Metallschicht auf die nicht abgedeckten Bereiche, zum Aufbau einer aus Erhebungen bestehenden Oberflächenstruktur, **dadurch gekennzeichnet, dass** Maske und Metallschicht mehrmalig schichtweise aufgetragen werden, und dass auf eine Ätzung des Pressbleches (1), Endlosband bzw. der Prägewalze bei diesen Verfahrensschritten gänzlich verzichtet wird.

2. Verfahren nach Anspruch 1,**dadurch gekennzeichnet,**
**dass** die Maske durch eine digitale Drucktechnik aufgetragen wird.

3. Verfahren nach Anspruch 2, **dadurch gekennzeichnet, dass** ein UV-Lack verwendet wird, welcher nach dem Auftragen durch eine UV-Quelle zum Aushärten bestrahlt wird.

4. Verfahren nach einem der Ansprüche 1, 2 oder 3,
**dadurch gekennzeichnet,**
**dass** die nachfolgenden Masken auf annähernd die gleichen partiellen Bereiche aufgetragen werden.

5. Verfahren nach einem der Ansprüche 1 bis 4,
**dadurch gekennzeichnet,**
**dass** die Metallschichten übereinander aufgetragen werden, wodurch eine schichtweise erhabene Struktur senkrecht zur Oberfläche des Presswerkzeuges aufgebaut wird.

6. Verfahren nach einem der Ansprüche 1 bis 5,
**dadurch gekennzeichnet,**
**dass** die nachfolgenden deckungskonformen Masken eine Strichbreite aufweisen, die kontinuierlich ansteigt.

7. Verfahren nach einem der Ansprüche 1 bis 6,
**dadurch gekennzeichnet,**
**dass** die nachfolgenden Metallschichten pyramidenförmig übereinander angeordnet sind.

8. Verfahren nach einem der Ansprüche 1 bis 7,
**dadurch gekennzeichnet,**
**dass** die Oberfläche des Presswerkzeuges vor der ersten Maskenauftragung galvanisch, chemisch oder mechanisch vorbehandelt wird.

9. Verfahren nach einem der Ansprüche 1 bis 8,
**dadurch gekennzeichnet,**
**dass** die Oberfläche des Presswerkzeuges nach dem Aufbringen der letzten Metallschicht einer galvanischen, chemischen oder mechanischen Behandlung unterzogen wird.

10. Verfahren nach einem der Ansprüche 1 bis 9,
**dadurch gekennzeichnet,**
**dass** eine nachfolgende Oberflächenbearbeitung durch Elektropolieren oder mechanisches Polieren erfolgt, oder dass eine nachfolgende Oberflächenbearbeitung durch Ätzen oder Mattätzen erfolgt.

11. Verfahren nach einem der Ansprüche 1 bis 10,
**dadurch gekennzeichnet,**
**dass** eine vollflächige und/oder partielle Glanzgradeinstellung als nachfolgende Oberflächenbehandlung erfolgt, wobei der Glanzgrad durch Auftragen einer metallischen Beschichtung, durch ein chemisches Verfahren oder durch ein mechanisches Verfahren erfolgt.

12. Verfahren nach einem oder mehreren der Ansprüche 1 bis 11,
**dadurch gekennzeichnet,**
**dass** eine vollständige und/oder partielle Hartverchromung (10) der Oberflächenstruktur als nachfolgende Oberflächenbehandlung erfolgt.

## Claims

1. A method for producing a surface structure on a pressing tool, which is designed as a pressing plate (1), an endless belt or an embossing roller, comprising at least the steps:
- at least a onetime application of a mask in order to cover partial regions and
- at least a onetime application of a metal layer to the non-covered regions in order to construct a surface structure composed of elevations,
**characterized in that** the mask and the metal layer are applied several times, layer by layer, and that etching of the pressing plate (1), the endless belt and/or the embossing roller is entirely dispensed with during these method steps.

2. The method according to claim 1, **characterized in that** the mask is applied by means of a digital printing technique.

3. The method according to claim 2, **characterized in that** a UV lacquer is used which, after the application, is irradiated by means of a UV source for the purpose of curing.

4. The method according to one of claims 1, 2, or 3, **characterized in that** the successive masks are applied to approximately the same partial regions.

5. The method according to one of claims 1 to 4, **characterized in that** the metal layers are applied one on top of the other, thereby constructing a structure elevated layer by layer perpendicular to the surface of the pressing tool.

6. The method according to one of claims 1 to 5, **characterized in that** the successive congruent masks have a stroke width, which continuously increases.

7. The method according to one of claims 1 to 6, **characterized in that** the successive metal layers are disposed one on top of the other in a pyramid shape.

8. The method according to one of claims 1 to 7, **characterized in that** the surface of the pressing tool is galvanically, chemically or mechanically pre-treated prior to the application of the first mask.

9. The method according to one of claims 1 to 8, **characterized in that** the surface of the pressing tool is subjected to a galvanic, chemical or mechanical treatment after the application of the last metal layer.

10. The method according to one of claims 1 to 9, **characterized in that** a subsequent surface treatment is carried out by means of electro-polishing or mechanical polishing or that a subsequent surface treatment is carried out by means of etching or matt etching.

11. The method according to one of claims 1 to 10, **characterized in that** a full-surface and/or a partial establishment of the degree of gloss is performed as a subsequent surface treatment, wherein the degree of gloss is established by means of the application of a metal coating, by means of a chemical process or by means of a mechanical process.

12. The method according to one or more of claims 1 to 11, **characterized in that** a complete and/or partial hard chrome plating (10) of the surface structure is performed as a subsequent surface treatment.

## Revendications

1. Procédé de fabrication d'une structure de surface sur un outil de presse qui est réalisé en tant que tôle de compression (1), bande sans fin ou cylindre de gaufrage, comprenant au moins les étapes :
- application au moins une fois d'un masque pour couvrir des zones partielles et
- application au moins une fois d'une couche métallique sur les zones non couvertes pour la constitution d'une structure de surface composée de reliefs,
**caractérisé en ce que**
le masque et la couche métallique sont appliqués par couches, et **en ce que**, dans ces étapes de procédé, il est totalement renoncé à une attaque à l'acide de la tôle de compression (1), de la bande sans fin ou respectivement du cylindre de gaufrage.

2. Procédé selon la revendication 1, **caractérisé en ce que** le masque est appliqué par une technique d'impression numérique.

3. Procédé selon la revendication 2, **caractérisé en ce qu'**un vernis UV est utilisé, lequel est, après l'application, exposé à une source UV pour le durcissement.

4. Procédé selon l'une des revendications 1, 2 ou 3, **caractérisé en ce que** les masques suivants sont appliqués sur à peu près les mêmes zones partielles.

5. Procédé selon l'une des revendications 1 à 4, **caractérisé en ce que** les couches métalliques sont appliquées les unes au-dessus des autres, créant ainsi une structure en relief par couches perpendiculairement à la surface de l'outil de presse.

6. Procédé selon l'une des revendications 1 à 5, **caractérisé en ce que** les masques suivants coïncidents présentent une largeur de trait qui augmente de façon continue.

7. Procédé selon l'une des revendications 1 à 6, **caractérisé en ce que** les couches métalliques suivantes sont disposées les unes au-dessus des autres en forme de pyramide.

8. Procédé selon l'une des revendications 1 à 7, **caractérisé en ce que** la surface de l'outil de presse est prétraitée galvaniquement, chimiquement ou mécaniquement avant l'application des masques.

9. Procédé selon l'une des revendications 1 à 8, **caractérisé en ce que**, après l'application de la dernière couche métallique, la surface de l'outil de presse est soumise à un traitement galvanique, chimique ou mécanique.

10. Procédé selon l'une des revendications 1 à 9, **caractérisé en ce qu'**un traitement de surface suivant est effectué par polissage électrolytique ou par polissage mécanique, ou **en ce qu'**un traitement de surface suivant est effectué par attaque à l'acide ou par matage à l'acide.

11. Procédé selon l'une des revendications 1 à 10, **caractérisé en ce qu'**un réglage du degré de brillance sur toute la surface et/ou partiel est effectué en tant que traitement de surface suivant, dans lequel le degré de brillance est effectué par l'application d'un revêtement métallique, par un procédé chimique ou par un procédé mécanique.

12. Procédé selon l'une ou plusieurs des revendications 1 à 11, **caractérisé en ce qu'**un chromage dur (10) complet et/ou partiel de la structure de surface est effectué en tant que traitement de surface suivant.
